# EUROPÄISCHE PATENTSCHRIFT

(11) **EP 2 614 232 B1**
(45) Veröffentlichungstag und Bekanntmachung des Hinweises auf die Patenterteilung: **25.11.2015**
(21) Anmeldenummer: 11746561.7
(22) Anmeldetag: 22.08.2011
(51) Int. Cl.: F01N 5/02, H01L 35/32

(54) **THERMOELEKTRISCHES MODUL FÜR EINEN THERMOELEKTRISCHEN GENERATOR EINES FAHRZEUGS MIT EINEM DICHTELEMENT**
THERMOELECTRIC MODULE FOR A THERMOELECTRIC GENERATOR OF A VEHICLE WITH A SEALING ELEMENT
MODULE THERMOÉLECTRIQUE POUR UN GÉNÉRATEUR THERMOÉLECTRIQUE D'UN VÉHICULE MUNI D'UN ÉLÉMENT D'ÉTANCHÉITÉ

(30) Priorität: 09.09.2010 DE 102010044803
(43) Veröffentlichungstag der Anmeldung: 17.07.2013
(73) Patentinhaber: Continental Automotive GmbH, 30165 Hannover (DE)
(72) Erfinder: BRÜCK, Rolf, 51429 Bergisch Gladbach (DE); LIMBECK, Sigrid, 53804 Much (DE)
(74) Vertreter: Rössler, Matthias
(86) Internationale Anmeldenummer: PCT/EP2011/064409
(87) Internationale Veröffentlichungsnummer: WO 2012/031881

(56) Entgegenhaltungen:
- DE-A1-102006 039 024
- DE-A1-102008 060 968
- US-A- 4 056 406

## Beschreibung

Die vorliegende Erfindung betrifft ein thermoelektrisches Modul, insbesondere für den Einsatz in einem thermoelektrischen Generator, der in einem Fahrzeug zum Einsatz kommt, wobei das thermoelektrische Modul mindestens ein Dichtelement aufweist.

Das Abgas aus einer Verbrennungskraftmaschine eines Kraftfahrzeugs besitzt thermische Energie, welche mittels eines thermoelektrischen Generators in elektrische Energie umgewandelt werden kann, um bspw. eine Batterie oder einen anderen Energiespeicher zu füllen und/oder elektrischen Verbrauchern die benötigte Energie direkt zuzuführen. Damit wird das Kraftfahrzeug mit einem verbesserten energetischen Wirkungsgrad betrieben und es steht für den Betrieb des Kraftfahrzeugs Energie in größerem Umfang zur Verfügung.

Ein solcher thermoelektrischer Generator weist zumindest ein thermoelektrisches Modul auf. Thermoelektrische Module umfassen z. B. wenigstens zwei Halbleiterelemente (p-dotiert und n-dotiert), die auf ihrer Oberseite und Unterseite (hin zur Heißseite bzw. zur Kaltseite) wechselseitig mit elektrisch leitenden Brücken versehen sind. Diese zwei Halbleiterelemente bilden die kleinste thermoelektrische Einheit bzw. ein thermoelektrisches Element. Thermoelektrische Materialien sind von einer Art, dass diese effektiv thermische Energie in elektrische Energie umwandeln können (Seebeck-Effekt) und umgekehrt (Peltier-Effekt). Wird ein Temperaturgefälle beidseits der Halbleiterelemente bereitgestellt, so bildet sich zwischen den Enden der Halbleiterelemente ein Spannungspotential aus. Die Ladungsträger auf der heißeren Seite werden durch die höhere Temperatur vermehrt in das Leitungsband angeregt. Durch den dabei erzeugten Konzentrationsunterschied im Leitungsband diffundieren Ladungsträger auf die kältere Seite des Halbleiterelements, wodurch die Potentialdifferenz entsteht. In einem thermoelektrischen Modul sind bevorzugt zahlreiche Halbleiterelemente elektrisch in Reihe geschaltet. Damit sich die generierten Potentialdifferenzen der seriellen Halbleiterelemente nicht gegenseitig aufheben, sind stets wechselweise Halbleiterelemente mit unterschiedlichen Majoritätsladungsträgern (n-dotiert und p-dotiert) in direkten elektrischen Kontakt gebracht. Mittels eines angeschlossenen Lastwiderstands kann der Stromkreis geschlossen und somit eine elektrische Leistung abgegriffen werden.

Um eine dauerhafte Einsatzfähigkeit der Halbleiterelemente zu gewährleisten, wird zwischen elektrisch leitenden Brücken und dem thermoelektrischen Material regelmäßig eine Diffusionsbarriere angeordnet, die ein Diffundieren von in den elektrischen Brücken enthaltenem Material in das thermoelektrische Material verhindert und damit einen Effektivitätsverlust bzw. ein funktionelles Versagen des Halbleitermaterials bzw. des thermoelektrischen Elements verhindert. Der Aufbau von thermoelektrischen Modulen bzw. der Halbleiterelemente erfolgt üblicherweise durch den Zusammenbau der einzelnen Komponenten thermoelektrisches Material, Diffusionsbarriere, elektrisch leitende Brücken, Isolierung und ggf. weiteren Gehäuseelementen zu einem thermoelektrischen Modul, das von einem heißen bzw. kalten Medium überströmt wird. Dieser Zusammenbau zahlreicher einzelner Komponenten erfordert auch eine genaue Abstimmung der einzelnen Bauteiltoleranzen und eine Berücksichtigung der Wärmeübergänge von der Heiß- zur Kaltseite sowie der hinreichenden Kontaktierung der elektrisch leitenden Brücken, so dass ein Stromfluss durch das thermoelektrische Material erzeugt werden kann.

Für die Anordnung solcher Halbleiterelemente in einem thermoelektrischen Modul sind regelmäßig Gehäusewände und/oder Stützrohre zur äußeren Begrenzung des Moduls vorgesehen, an denen die Halbleiterelemente befestigt sind. Dies führt insbesondere dazu, dass bei der Fertigung hohe Toleranzanforderungen gegeben sind, um einerseits eine passgenaue Anordnung der Halbleiterelemente mit Bezug auf die elektrischen Verbindungen sowie auf die Position der Gehäuse zu realisieren. Problematisch ist darüber hinaus, dass infolge der unterschiedlichen thermischen Belastungen der äußeren und inneren Gehäuseteile auch unterschiedliche Ausdehnungsverhalten dieser Komponenten kompensiert elektrische Material eingeleitet werden. Gerade im Hinblick auf eine Fertigung von thermoelektrischen Modulen ist gewünscht, die Vielzahl von Bauteilen leicht miteinander kombinieren zu können, die Lagerung und die Handhabung zu vereinfachen und auch beim Zusammenbau eine leichte, aber stabile, Struktur zu erzeugen. Die oben genannten Anforderungen gelten gleichermaßen auch für Dichtelemente, die die jeweiligen Enden eines insbesondere rohrförmigen thermoelektrischen Moduls abdichten sollen, so dass das heiße Medium oder das kalte Medium, das das thermoelektrische Modul auf jeweils einer Seite umgibt, dauerhaft von den im thermoelektrischen Modul angeordneten thermoelektrischen Elementen getrennt bleibt. Gerade bei diesen Bauteilen ist vor dem Hintergrund der Abdichtung des thermoelektrischen Moduls gegenüber gasförmigen und/oder flüssigen Medien eine möglichst robuste Konstruktion erforderlich, so dass zu hohe Anforderungen hinsichtlich Passgenauigkeit oder hinsichtlich des Zusammenbaus solcher Dichtelemente vermieden werden können.

Die US 4,056,406 betrifft ein rohrförmiges thermoelektrisches Modul, das an seinen jeweiligen Enden durch Abschlusselemente verschlossen wird. Diese Abschlusselemente weisen eine gegenüber dem Abschlusselement elektrisch isolierte Durchführung für einen elektrischen Leiter auf. Das Abschlusselement ist auf dem inneren, wärmeleitenden Stützrohr angeordnet.

Die DE 10 2008 060 968 A1 ist auf ein rohrförmiges thermoelektrisches Modul gerichtet. Die jeweiligen Stirnseiten sind durch Stirnwände abgeschlossen, die zwischen Innenrohr und Außenrohr angeordnet und mit diesen bspw. über eine Emailleschicht abdichtend verbunden sind. Durch die Stirnwände erstreckt sich ein ringförmiger elektrischer Leiter.

Hiervon ausgehend ist es Aufgabe der vorliegenden Erfindung, die mit Bezug auf den Stand der Technik geschilderten Probleme zumindest teilweise zu lösen. Insbesondere soll ein thermoelektrisches Modul angegeben werden, das gegenüber dem heißen Medium bzw. dem kalten Medium abgedichtet werden kann und gleichzeitig technisch einfach herstellbar ist und eine reduzierte Teilezahl aufweist. Weiterhin soll es für den gewünschten Einsatz dauerfest ausgeführt sein und zudem einen hohen Wirkungsgrad aufweisen, um aus der thermischen Energie eines Abgases ein Höchstmaß an elektrischer Energie zu erzeugen.

Diese Aufgaben werden gelöst mit einem thermoelektrischen Modul gemäß den Merkmalen des Patentanspruchs 1. Weitere vorteilhafte Ausgestaltungen der Erfindung sind in den abhängig formulierten Patentansprüchen angegeben. Die in den Patentansprüchen einzeln aufgeführten Merkmale sind in beliebiger, technologisch sinnvoller Weise miteinander kombinierbar und zeigen weitere Ausgestaltungen der Erfindung auf. Die Beschreibung, insbesondere im Zusammenhang mit den Figuren, erläutert die Erfindung weiter und führt ergänzende Ausführungsbeispiele der Erfindung an.

Das erfindungsgemäße rohrförmige thermoelektrische Modul weist eine Innenumfangsfläche und eine Außenumfangsfläche auf, die jeweils einer Heißseite oder einer Kaltseite zugeordnet sind. Zwischen der Innenumfangsfläche und der Außenumfangsfläche ist ein Zwischenraum angeordnet. Das thermoelektrische Modul weist eine geometrische Achse und mindestens ein Dichtelement auf, wobei das Dichtelement zumindest teilweise die Innenumfangsfläche bildet oder nur durch eine elektrische Isolationsschicht von der dort angeordneten Heißseite oder Kaltseite getrennt ist. Weiter dichtet das Dichtelement den Zwischenraum zumindest gegenüber der Kaltseite ab. Weiterhin weist das Dichtelement mindestens einen elektrischen Leiter auf, der mindestens ein im thermoelektrischen Modul angeordnetes thermoelektrisches Element mit mindestens einem zweiten elektrischen Leiter verbindet, der selbst außerhalb des thermoelektrischen Moduls angeordnet ist.

Bevorzugt bildet das Dichtelement zudem zumindest teilweise die Außenumfangsfläche des thermoelektrischen Moduls bzw. ist nur durch eine elektrische Isolierung von der an der Außenumfangsfläche angeordneten Kaltseite oder Heißseite getrennt. Insbesondere dichtet das Dichtelement auch zusätzlich den Zwischenraum gegenüber der Heißseite ab.

Das thermoelektrische Modul stellt insbesondere eine separate Baueinheit eines thermoelektrischen Generators dar. Bevorzugt ist dabei, dass das thermoelektrische Modul einen Anschluss aufweist, mit dem ein solches thermoelektrisches Modul ggf. mit einer Vielzahl weiterer thermoelektrischer Module elektrisch verschaltet werden kann. Innerhalb des thermoelektrischen Moduls ist also insbesondere die elektrische Verbindung bzw. Verschaltung aller dort integrierten thermoelektrischen Elemente realisiert. Ein solches thermoelektrisches Modul wird nun einerseits auf einer Heißseite einem heißen Medium und auf einer Kaltseite einem kalten Medium ausgesetzt. Hierbei steht insbesondere im Fokus, dass das thermoelektrische Modul über seine Außenumfangsfläche mit einem kalten Medium und über seine Innenumfangsfläche mit einem heißen Medium (insbesondere Abgas) in Kontakt gebracht wird bzw. von diesen Medien durchströmt/umströmt wird. Damit bildet praktisch die Innenumfangsfläche eine sogenannte Heißseite und die Außenumfangsfläche eine sogenannte Kaltseite des thermoelektrischen Moduls aus.

Weiterhin ist bevorzugt, dass das thermoelektrische Modul länglich ausgeführt ist, also bspw. nach Art einer Schiene oder eines Rohrs. Auch wenn ganz besonders bevorzugt ist, dass das thermoelektrische Modul in etwa wie ein Zylinder bzw. ein Rohr gestaltet ist, ist eine solche Form nicht zwingend. Insbesondere können auch ovale Querschnitte oder polygonale Querschnitte für ein solches thermoelektrisches Modul in Betracht gezogen werden. Entsprechend dieser Gestalt lässt sich nun auch eine zentrale geometrische Achse sowie eine Innenumfangsfläche und eine Außenumfangsfläche identifizieren. Die Innenumfangsfläche begrenzt dabei insbesondere einen inneren Kanal, durch den das heiße Medium (Abgas) hindurchströmen kann. Zwischen dieser Innenumfangsfläche und der Außenumfangsfläche sind die thermoelektrischen Elemente in einem Zwischenraum des thermoelektrischen Moduls positioniert. Eine Vielzahl solcher thermoelektrischer Elemente können in Richtung der geometrischen Achse des thermoelektrischen Moduls aufeinander gestapelt angeordnet sein, insbesondere nach einer Art, dass abwechselnd ein Halbleiterelement mit p-dotiertem thermoelektrischen Material und ein Halbleiterelement mit n-dotiertem thermoelektrischen Material benachbart zueinander angeordnet sind. Insofern ist ganz besonders bevorzugt, dass sich das Halbleiterelement mit einer vorgegebenen Dotierung vollständig um die Innenumfangsfläche herum erstreckt, bspw. nach Art von Scheiben oder Ringen. Dieses thermoelektrische Material ist nun eingefasst von elektrisch leitenden Brücken, die im Folgenden als Verbindungselemente bezeichnet werden. Das thermoelektrische Material ist nun zumindest teilweise eingefasst von diesen Verbindungselementen, so dass eine Innenumfangsfläche und eine Außenumfangsfläche durch die Verbindungselemente gebildet ist. Die Verbindungselemente umschließen bevorzugt das thermoelektrische Material innen und außen jeweils vollständig. Entsprechend der Form des Halbleiterelements sind die Verbindungselemente bspw. nach Art von Ringen bzw. (Hohl-)Zylindern ausgeführt.

Besonders bevorzugt ist, dass das thermoelektrische Material mit den Verbindungselementen kraftschlüssig verbunden (verpresst) ist, insbesondere ohne den Einsatz von Lötmaterial oder von einem Kleber. Weiterhin ist bevorzugt, dass die Verbindungselemente gleichzeitig eine Diffusionsbarriere für das thermoelektrische Material sowie einen elektrischen Stromleiter ausbilden. Als Material für diese Verbindungselemente werden Nickel oder Molybdän bevorzugt, wobei diese jeweils ganz besonders bevorzugt mit zumindest 95 Massen-% im Werkstoff der Verbindungselemente vorhanden sind.

Die thermoelektrischen Materialien bzw. die Halbleiterelemente sind nun elektrisch miteinander wechselweise über die Verbindungselemente verbunden, so dass sich aufgrund der Temperaturdifferenz zwischen der Innenumfangsfläche und der Außenumfangsfläche ein elektrischer Stromfluss durch die thermoelektrischen Materialien und das thermoelektrische Modul hindurch ausbildet. Die elektrische Verbindung zwischen den thermoelektrischen Materialien kann auch über eine metallische Brücke, ein Kabel, Lötmaterial oder dergleichen realisiert sein. Wie bereits ausgeführt, ist die elektrische Verbindung bevorzugt (nur) mittels des Verbindungselementes realisiert.

Das erfindungsgemäß vorgesehene Dichtelement schließt nun den Zwischenraum des thermoelektrischen Moduls an den jeweiligen Enden des thermoelektrischen Moduls nach außen hin ab, so dass der Zwischenraum zumindest gegenüber der Kaltseite, bevorzugt aber auch gegenüber der Heißseite, abgedichtet ist, so dass ein kaltes Medium bzw. ein heißes Medium nicht in den Zwischenraum eindringen kann. Dabei ist das Dichtelement bevorzugt ein gesondertes Bauteil und wird nicht durch die Halbleitermaterialien, die Verbindungselemente oder durch ein äußeres oder inneres Rohr, das das thermoelektrische Modul umschließt, gebildet. Das Dichtelement hat damit eine Ausdehnung in Richtung der Achse, die höchstens 20 %, bevorzugt höchstens 10 % der Länge des Zwischenraums des thermoelektrischen Moduls beträgt. Die Länge des Zwischenraums des thermoelektrischen Moduls wird durch die größte Distanz der Halbleitermaterialien voneinander in Richtung der Achse definiert. Dabei weist das Dichtelement mindestens einen elektrischen Leiter auf, der mindestens ein Verbindungselement innerhalb des thermoelektrischen Moduls kontaktiert und somit einen im thermoelektrischen Modul erzeugten elektrischen Strom durch das Dichtelement hindurch nach außen zu einem zweiten elektrischen Leiter durchleiten kann.

Das Dichtelement bildet insbesondere zumindest teilweise die Innenumfangsfläche und die Außenumfangsfläche. Das bedeutet, dass das Dichtelement unmittelbar von dem heißen und/oder kalten Medium überströmt wird. Ggf. ist das Dichtelement nur durch die Hülle gegenüber der an der Außenumfangsfläche angeordneten Kaltseite getrennt, so dass über das Dichtelement ein Wärmestrom zwischen Kaltseite und Heißseite fließen kann. Da das Dichtelement jedoch keine große Ausdehnung in Richtung der Achse aufweist, kann dieser Wärmestrom auch ohne zusätzliche thermische Isolierung des Dichtelements den Wirkungsgrad des thermoelektrischen Moduls nur in geringem Maße beeinflussen. Eine Abdichtung des Zwischenraums gegenüber der Kaltseite und/oder der Heißseite erfolgt insbesondere durch eine stoffschlüssige Verbindung des Dichtelements mit den die Außenumfangsfläche und/oder die Innenumfangsfläche erzeugenden Verbindungselementen. Bevorzugt ist das Dichtelement über den elektrischen Leiter mit den an der Innenumfangsfläche angeordneten Verbindungselementen elektrisch leitend verbunden, so dass hier eine Abdichtung des Zwischenraums gegenüber der an der Innenumfangsfläche des thermoelektrischen Moduls angeordneten Heißseite gewährleistet ist. Die Abdichtung an der Außenumfangsfläche wird bevorzugt durch die Bildung einer Dichtfläche zwischen Hülle und Dichtelement erzeugt. Die Hülle dient insbesondere der elektrischen Isolation der Verbindungselemente gegenüber der Kaltseite. Eine solche elektrische Isolationsschicht kann auch an der Innenumfangsfläche des thermoelektrischen Moduls vorgesehen werden. Auch diese elektrische Isolationsschicht kann insbesondere nach Montage des Dichtelements an der Innenumfangsfläche des thermoelektrischen Moduls dort angeordnet werden. In diesem Fall ist das Dichtelement nur durch die elektrische Isolationsschicht von der an der Innenumfangsfläche des thermoelektrischen Moduls angeordneten Kaltseite oder Heißseite getrennt.

Da das Dichtelement zumindest teilweise die Innenumfangsfläche und insbesondere zusätzlich die Außenumfangsfläche des thermoelektrischen Moduls bildet, ist eine einfache konstruktive Lösung gefunden, den Zwischenraum des thermoelektrischen Moduls abzudichten und gleichzeitig den im thermoelektrischen Modul erzeugten elektrischen Strom nach außen abzuführen. Bevorzugt ist, dass das erfindungsgemäße Dichtelement an beiden Enden des thermoelektrischen Moduls vorgesehen ist, wobei unterschiedliche Ausführungen des Dichtelements an einem thermoelektrischen Modul angeordnet werden können.

Gemäß einer besonders bevorzugten Ausgestaltung ist das Dichtelement einteilig ausgeführt. Somit wird ermöglicht, dass das thermoelektrische Modul durch das Hinzufügen eines einzigen Teils einerseits zumindest gegenüber der Kaltseite abgedichtet und andererseits elektrisch leitend mit einem außerhalb des thermoelektrischen Moduls angeordneten zweiten elektrischen Leiter verbunden wird. Somit wird eine einfache Lösung realisiert, die eine kostengünstige Montage und dauerhafte Einsatzfähigkeit des thermoelektrischen Moduls gewährleisten kann. Einteilig heißt hier, dass das Dichtelement vor dem Zusammenbau mit dem thermoelektrischen Modul eine einzige Baueinheit bildet, die insbesondere aus mehreren einzelnen Komponenten hergestellt ist, die kraft-, form- oder stoffschlüssig miteinander verbunden sind.

Gemäß einer weiteren, besonders bevorzugten, Ausführung des thermoelektrischen Moduls ist das Dichtelement aus mehreren Schichten gebildet und erfüllt zumindest die folgenden Funktionen:
- Bildung eines elektrischen Leiters zur Leitung eines elektrischen Stroms durch das Dichtelement in einer Richtung der Achse,
- Isolationsschicht zur elektrischen Isolation in einer radialen Richtung des thermoelektrischen Moduls,
- Abdichtung des Zwischenraums gegenüber einem flüssigen und/oder einem gasförmigen Medium.

Insbesondere wird das Dichtelement daher aus mindestens einer keramischen Isolationsschicht und mindestens einer elektrischen Leiterschicht aufgebaut, die in radialer Richtung übereinander sich in Richtung der Achse durch das Dichtelement erstrecken und damit das Dichtelement erzeugen. Das keramische Material, das zur elektrischen und ggf. auch thermischen Isolation des Dichtelements geeignet ist, wird ggf. von metallischen Tragelementen eingefasst und entsprechend stabilisiert. Zudem kann anstatt der keramischen Isolationsschicht eine Schicht aus Glimmer verwendet werden. Bevorzugt ist der elektrische Leiter zumindest auf einer Seite in das keramische Material eingebettet oder mit dem Glimmermaterial verbunden, wobei bevorzugt das Dichtelement und auch die einzelnen Schichten jeweils ring- oder ringsegmentförmig ausgestaltet und ineinander angeordnet sind. Bevorzugt sind die einzelnen Schichten miteinander verpresst, so dass zumindest eine kraftschlüssige, wenn möglich aber auch eine stoffschlüssige Verbindung zwischen den einzelnen Schichten erzeugt ist. Der elektrische Leiter des Dichtelements steht bevorzugt in Richtung der Achse aus dem Dichtelement hervor und kann somit insbesondere stoffschlüssig z. B. durch Schweißen oder Löten mit den Verbindungselementen des thermoelektrischen Moduls elektrisch leitend verbunden werden, so dass ein Stromfluss durch das thermoelektrische Modul über den elektrischen Leiter zu einem zweiten elektrischen Leiter geleitet werden kann. Durch den Einsatz eines Glimmermaterials kann eine rein kraftschlüssige Verbindung zwischen Tragelement(-en), elektrischem Leiter und der Isolationsschicht erreicht werden. Hier kann also auf eine stoffschlüssige Verbindung (durch z. B. Löten) verzichtet werden. Durch das Verpressen der einzelnen Schichten miteinander kann somit eine flexible Verbindung der Isolationsschicht mit dem elektrischen Leiter bzw. mit dem Tragelement erreicht werden, so dass Wärmeausdehnungen in radialer und axialer Richtung ausgeglichen werden können. Weiterhin ist so eine kraftschlüssige Verbindung besser geeignet die erheblichen Kräfte, die infolge der Fixierung des thermoelektrischen Moduls an einem thermoelektrischen Generator oder einem Gehäuse durch die Befestigung über das Dichtelement übertragen werden, dauerhaft aufzunehmen. Die Übertragung der Haltekräfte über eine keramische Isolationsschicht könnte hier eher zu einem Versagen des Dichtelements führen.

Glimmer (Mica) sind Phyllosilikate, in welchen die Einheitsstruktur aus einem oktaedrischen Blatt (Os) zwischen zwei gegenübergesetzten tetraedrischen Blättern (Ts) bestehen. Diese Blätter bilden eine Schicht, welche von benachbarten Schichten durch Flächen nicht-hydratierter Zwischenlagen-Kationen (I) getrennt sind. Die Sequenz ist: .... I Ts Os Ts I Ts Os Ts ...... Die Ts haben die Zusammensetzung T₂O₅. Die koordinierenden Anionen um die oktaedrisch koordinierten Kationen (M) bestehen aus Sauerstoffatomen benachbarter Ts und Anionen A. Die Koordination der Zwischenlagen-Kationen ist nominal 12-fach, mit einer vereinfachten Formel, welche wie folgt geschrieben werden kann:

IM₂₋₃X₁₋₀T₄O₁₀A₂

wobei
I = Cs, K, Na, NH4, Rb, Ba, Ca
M = Li, Fe⁺⁺ oder⁺⁺⁺, Mg, Mn⁺⁺ oder⁺⁺⁺, Zn, Al, Cr, V, Ti
T = Be, Al, B, Fe⁺⁺⁺, Si
A = Cl, F, OH, O (Oxy-Glimmer), S.

Ganz besonders bevorzugt sind hierbei folgende Materialien: Mikanite (d. h. insbesondere Glimmerbruchstücke, die mit Kunstharz zu großen Glimmerfolien verpresst und verbacken werden) mit hohen Wärmeleitwiderständen.

Eine weitere besondere Ausführung des thermoelektrischen Moduls ist darauf gerichtet, dass das Dichtelement zumindest eine elektrische Isolationsschicht aufweist, und die Isolationsschicht zumindest teilweise ein Glimmermaterial umfasst. Dabei ist die Isolationsschicht nur kraftschlüssig mit dem Dichtelement verbunden. Das Dichtelement weist insbesondere weitere Teile auf (Tragelemente, Verbindungselemente), die miteinander stoffschlüssig, kraftschlüssig und/oder formschlüssig verbunden sind. Die Isolationsschicht ist aber nur kraftschlüssig mit den ggf. einzelnen Teilen des Dichtelements verbunden, z. B. durch Verpressen der Teile miteinander. Insbesondere ist die Isolationsschicht ausschließlich aus Glimmer gebildet.

Gemäß einer weiteren bevorzugten Ausführung des thermoelektrischen Moduls ist die Außenumfangsfläche des thermoelektrischen Moduls zumindest teilweise durch eine Hülle gebildet und der Zwischenraum des thermoelektrischen Moduls gegenüber der Heißseite und/oder der Kaltseite zumindest durch eine Dichtfläche abgedichtet, die durch die Hülle und das Dichtelement gebildet wird. Die Hülle erstreckt sich insbesondere über den Verbindungselementen der Außenumfangsfläche und bildet damit die Außenumfangsfläche des thermoelektrischen Moduls. Diese Hülle umfasst entsprechend die thermoelektrischen Elemente des thermoelektrischen Moduls, die auf ihrer Außenseite durch Verbindungselemente zumindest teilweise elektrisch leitend miteinander verbunden sind. Die hier vorgeschlagene Hülle dichtet den Zwischenraum des thermoelektrischen Moduls gegenüber der Heißseite bzw. Kaltseite, die auf der Außenumfangsfläche angeordnet ist, ab und erzeugt zusammen mit dem Dichtelement eine Dichtfläche, so dass an den Enden des thermoelektrischen Moduls eine Abdichtung des Zwischenraums des thermoelektrischen Moduls durch das Dichtelement gewährleistet ist. Dabei kann das Dichtelement insbesondere eine in Umfangsrichtung umlaufende Dichtfläche aufweisen, die ihrerseits von der Hülle umschlossen wird. Insbesondere ist zwischen Hülle und Dichtfläche des Dichtelements ein Kleber angeordnet, der einerseits die Dauerfestigkeit der Verbindung von Hülle und Dichtelement gewährleistet und gleichzeitig eine verbesserte Abdichtung ermöglicht. Die Dichtfläche kann zudem auch (zusätzlich oder anstatt des Klebers) einen O-Ring aufweisen, der insbesondere im Dichtelement z. B. in einer Nut angeordnet ist oder aber auch in der Hülle selbst, wobei der O-Ring das Dichtelement in Umfangsrichtung umschließt. Bevorzugt ist die Hülle bei Anordnung des O-Rings in einer Nut des Dichtelements zusätzlich von einem weiteren Fixierungselement umgeben, das die Hülle gegen den O-Ring bzw. gegen die Dichtfläche drückt, so dass eine dauerhafte Abdichtung des Zwischenraums gewährleistet ist.

Diese Ausführung ist insbesondere auch an der Innenumfangsfläche des thermoelektrischen Moduls umsetzbar. In diesem Fall wird die Innenumfangsfläche des thermoelektrischen Moduls zumindest teilweise durch eine Hülle gebildet und der Zwischenraum zumindest durch eine Dichtfläche abgedichtet, die durch die Hülle und das Dichtelement gebildet wird. Entsprechend erstreckt sich die Hülle über die Verbindungselemente der Innenumfangsfläche und bildet damit die Innenumfangsfläche des thermoelektrischen Moduls. Diese Hülle umfasst folglich die thermoelektrischen Elemente des thermoelektrischen Moduls, die auf ihrer Innenseite durch Verbindungselemente zumindest teilweise elektrisch leitend miteinander verbunden sind. Die hier vorgeschlagene Hülle dichtet den Zwischenraum des thermoelektrischen Moduls gegenüber der Heißseite bzw. Kaltseite, die auf der Innenumfangsfläche angeordnet ist, ab und erzeugt zusammen mit dem Dichtelement eine Dichtfläche, so dass an den Enden des thermoelektrischen Moduls eine Abdichtung des Zwischenraums gewährleistet ist. Die weiteren obigen Ausführungen hinsichtlich der Anordnung eines Klebers und/oder eines O-Rings gelten entsprechend.

Insbesondere ist weiterhin ein Fahrzeug mit einer Verbrennungskraftmaschine, einem Abgassystem und einem Kühlsystem vorgesehen, das einen thermoelektrischen Generator umfasst, der mindestens ein erfindungsgemäßes thermoelektrisches Modul aufweist. Das Abgassystem erstreckt sich durch die Innenumfangsfläche des thermoelektrischen Moduls hindurch und das Kühlsystem außen entlang der Außenumfangsfläche des thermoelektrischen Moduls. Das heißt mit anderen Worten auch, dass bspw. das kalte Medium des Kühlmittelsystems außen entlang der Außenumfangsfläche des thermoelektrischen Moduls vorbeigeführt wird, so dass die Außenumfangsfläche des thermoelektrischen Moduls die Kaltseite darstellt. Ebenso bedeutet das, dass das heiße Abgas innen durch einen Kanal, der durch die Innenumfangsfläche des thermoelektrischen Moduls begrenzt ist, hindurchströmt, so dass die Innenumfangsfläche dann die Heißseite darstellt. Besonders bevorzugt ist, dass der thermoelektrische Generator dabei nach Art eines Rohrbündels aufgebaut ist, wobei einerseits eine Vielzahl dieser thermoelektrischen Module dann an das Abgassystem angeschlossen ist, so dass diese von heißem Abgas durchströmt werden und andererseits die thermoelektrischen Module bspw. in einem gemeinsamen (beabstandeten) Gehäuse angeordnet sind, so dass diese gemeinsam von einem Kühlmittelstrom umströmt werden können. Selbstverständlich sind entsprechende elektrische Anschlüsse und Leitungen vorzusehen, um eine sichere Stromerzeugung und Weiterleitung des Stroms, des Kühlmittels und des Abgases zu realisieren. Insbesondere ist auch möglich, dass das kalte Medium des Kühlmittelsystems innen durch den Kanal, der durch die Innenumfangsfläche des thermoelektrischen Moduls begrenzt ist, hindurchströmt. In diesem Fall bildet die Außenumfangsfläche die Heißseite und die Innenumfangsfläche die Kaltseite.

Die Erfindung sowie das technische Umfeld werden nachfolgend anhand der Figuren näher erläutert. Es ist darauf hinzuweisen, dass die gezeigten Ausführungsbeispiele bevorzugt sind, die Erfindung jedoch nicht darauf beschränkt ist. Die Figuren zeigen schematisch:
- Fig. 1:: ein Fahrzeug mit einem thermoelektrischen Generator und einer Mehrzahl von thermoelektrischen Modulen,
- Fig. 2:: ein rohrförmiges thermoelektrisches Modul,
- Fig. 3:: ein Ende eines thermoelektrischen Moduls mit einem Dichtelement,
- Fig. 4:: ein Ende eines thermoelektrischen Moduls mit einem weiteren Dichtelement,
- Fig. 5:: ein Ende eines thermoelektrischen Moduls mit einem dritten Dichtelement und
- Fig. 6:: ein Ende eines thermoelektrischen Moduls mit einem vierten Dichtelement.

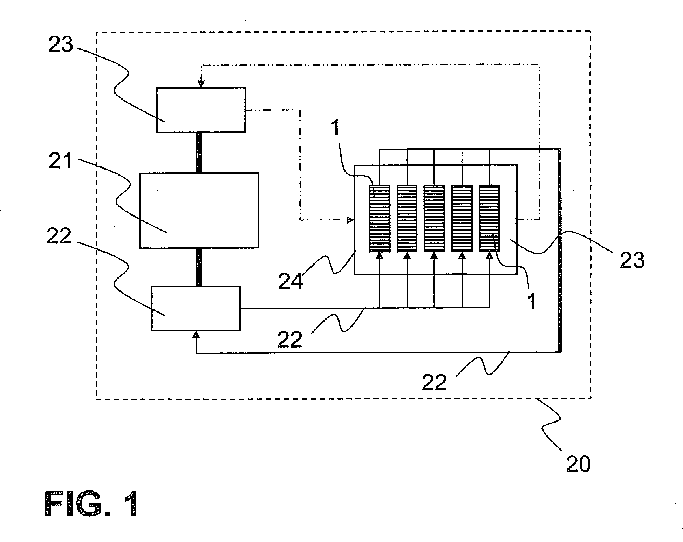

Fig. 1 zeigt ein Fahrzeug 20 mit einer Verbrennungskraftmaschine 21, einem Abgassystem 22 und einem Kühlsystem 23 sowie einem thermoelektrischen Generator 24 mit einer Mehrzahl von thermoelektrischen Modulen 1. Die thermoelektrischen Module 1 werden an das Abgassystem 22 angeschlossen, so dass ein Abgas durch die thermoelektrischen Module 1 hindurchströmt, wobei das Kühlsystem 23 so an den thermoelektrischen Generator 24 angeschlossen ist, dass die thermoelektrischen Module 1 außen von einem kalten Medium überströmt werden.

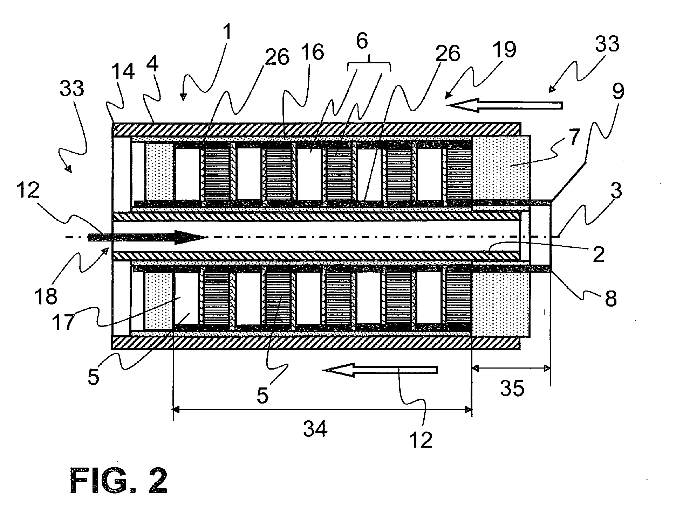

Fig. 2 zeigt ein rohrförmiges thermoelektrisches Modul 1 mit einer Innenumfangsfläche 2 und einer Außenumfangsfläche 4 sowie thermoelektrischen Elemente 6, die durch n- und p-dotierte Halbleiterelemente 5 gebildet werden, die miteinander elektrisch wechselseitig an der Innenumfangsfläche 2 und an der Außenumfangsfläche 4 über Verbindungselemente 26 verbunden sind. Diese thermoelektrischen Elemente 6 sind in einem Zwischenraum 17 angeordnet, der sich zwischen der Innenumfangsfläche 2 und der Außenumfangsfläche 4 entlang der Achse 3 des thermoelektrischen Moduls 1 erstreckt. Die Innenumfangsfläche 2 wird von einem (heißen) Medium 12 (Abgas) durchströmt, wobei die Außenumfangsfläche 4 von einem (kalten) Medium 12 (Kühlwasser) überströmt wird, so dass auf der Außenumfangsfläche 4 die sogenannte Kaltseite 19 und auf der Innenumfangsfläche 2 die sogenannte Heißseite 18 realisiert ist. Zwischen der Außenumfangsfläche 4 und den thermoelektrischen Elementen 6 bzw. den Verbindungselementen 26 ist weiterhin eine Isolationsschicht 16 angeordnet, so dass das Medium 12 auf der Kaltseite 19 von den Verbindungselementen 26 elektrisch isoliert ausgeführt ist. Das thermoelektrische Modul 1 weist an seinen jeweiligen Enden 33, die entlang der Achse 3 angeordnet sind, jeweils ein Dichtelement 7 auf, das hier innerhalb einer Hülle 14 angeordnet ist und zumindest teilweise die Außenumfangsfläche 4 bzw. die Innenumfangsfläche 2 bildet. Das Dichtelement 7 weist einen elektrischen Leiter 8 auf, der die Verbindungselemente 26 mit einem außerhalb des thermoelektrischen Moduls 1 angeordneten zweiten elektrischen Leiter 9 elektrisch leitend verbindet. Über diesen zweiten elektrischen Leiter 9 kann eine Mehrzahl von thermoelektrischen Modulen 1 miteinander in Reihe oder parallel geschaltet werden, so dass ein thermoelektrischer Generator aus einer Vielzahl von thermoelektrischen Modulen 1 aufgebaut werden kann. Der Zwischenraum 17 des thermoelektrischen Moduls 1 weist eine Länge in Richtung der Achse 3 auf, die durch die Distanz 34 der äußersten Halbleiterelemente 5 voneinander definiert ist. Das Dichtelement 7 weist eine Erstreckung 3 5 in Richtung der Achse 3 auf.

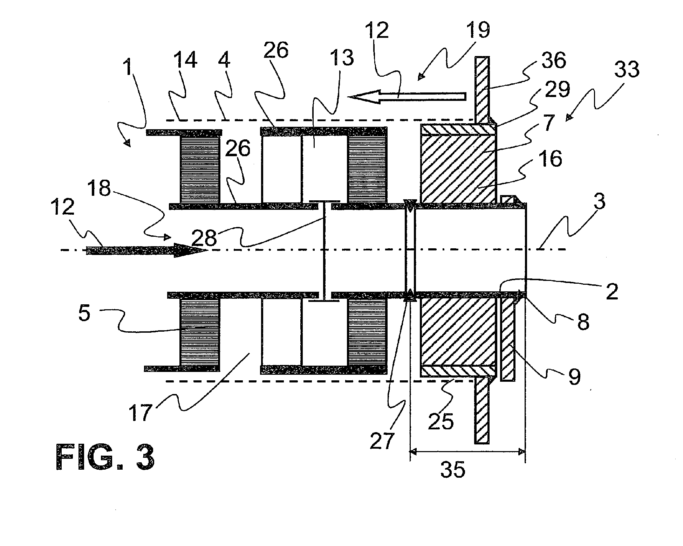

Fig. 3 zeigt ein Ende 33 eines thermoelektrischen Moduls 1 mit einem Dichtelement 7. Die Innenumfangsfläche 2 des thermoelektrischen Moduls 1 wird durch Verbindungselemente 26 und durch den elektrischen Leiter 8 des Dichtelements 7 zumindest teilweise gebildet und die Außenumfangsfläche 4 zumindest teilweise durch eine Hülle 14. Die Halbleiterelemente 5 sind jeweils n- und p-dotiert und abwechselnd elektrisch miteinander über Verbindungselemente 26 verbunden. Die Verbindungselemente 26 bilden hier keine geschlossene Innenumfangsfläche 2 bzw. Außenumfangsfläche 4, so dass zusätzlich zumindest auf der Innenumfangsfläche 2 Dichtungen 28 vorgesehen sind, die das Eindringen eines Mediums 12 von der Heißseite 18 in den Zwischenraum 17 des thermoelektrischen Moduls 1, bzw. in den Spalt 13 zwischen den Halbleiterelementen 5 verhindern.

Die Dichtungen 28 sind bevorzugt so ausgeführt, dass sie über die durch die Verbindungselemente 26 gebildete Innenumfangsfläche 2 in den durch die Innenumfangsfläche 2 umschlossenen Kanal hineinragen. Somit können durch die Dichtungen 28 Turbulenzerzeuger gebildet werden, die eine zusätzliche Verwirbelung des Mediums 12 bewirken und so den Wärmeübergang zwischen Medium 12 und thermoelektrischen Modul 1 verbessern.

Das Dichtelement 7 schließt das thermoelektrische Modul 1 am Ende 33 nach außen hin ab, so dass zumindest von der Kaltseite 19 ein Medium 12 nicht in den Zwischenraum 17 des thermoelektrischen Modul 1 eindringen kann. Zu diesem Zweck bildet sich zwischen der Hülle 14 und dem Dichtelement 7 eine Dichtfläche 25 aus, die hier durch ein Tragelement 29 gebildet ist, das eine elektrische und ggf. thermische Isolationsschicht 16 umschließt. Dieses Tragelement 29 dient der Stabilisierung der bevorzugt keramischen Isolationsschicht 16. Die Isolationsschicht 16 ihrerseits umschließt den elektrischen Leiter 8 des Dichtelements 7, der über eine Verbindungsstelle 27, die wie hier gezeigt über die Außenumfangsfläche 4 für ein Fügeverfahren zugänglich ist, mit den elektrisch leitenden Verbindungselementen 26 des thermoelektrischen Moduls 1 verbunden ist.

Hier ist vorgesehen, dass das Dichtelement 7 zumindest teilweise die Außenumfangsfläche 4 und die Innenumfangsfläche 2 des thermoelektrischen Moduls 1 bildet, wobei damit auch umfasst ist, dass lediglich eine zum Dichtelement 7 gehörende Befestigung 36 unmittelbar das Medium 12 kontaktiert. Durch die Befestigung 36 wird das thermoelektrische Modul 1, ggf. zusammen mit weiteren thermoelektrischen Modulen 1, in einem Gehäuse fixiert, so dass ein thermoelektrischer Generator gebildet wird. Die Erstreckung 35 des Dichtelements 7 in Richtung der Achse 3 wird hier durch den elektrischen Leiter 8 definiert, der an beiden Seiten des Dichtelements 7 übersteht. Der elektrische Leiter 8 kontaktiert einen zweiten elektrischen Leiter 9, durch den das thermoelektrische Modul 1 mit anderen thermoelektrischen Modulen 1 elektrisch parallel oder in Serie verschaltet werden kann.

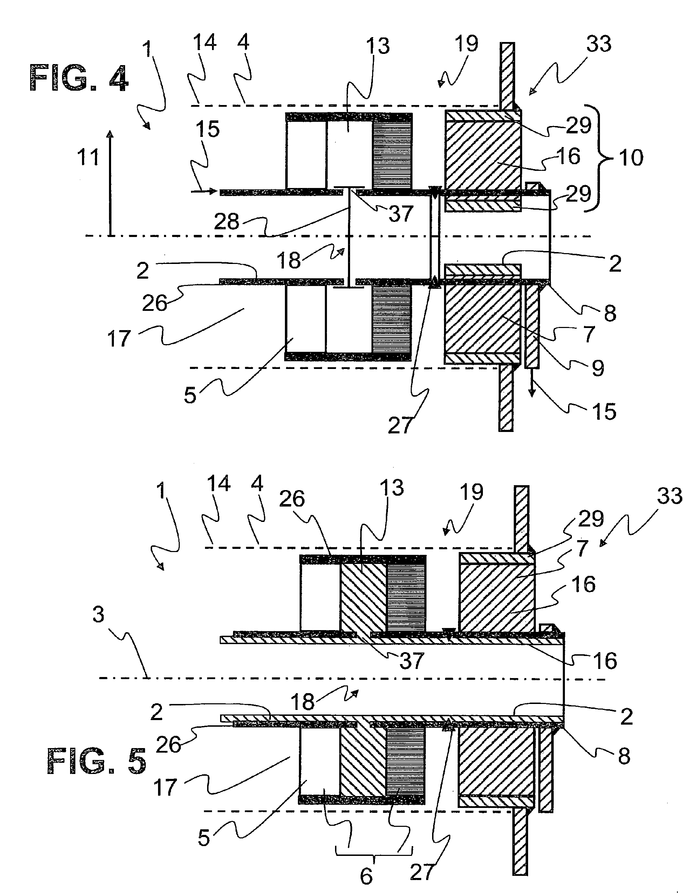

Fig. 4 zeigt ein Ende 33 eines thermoelektrischen Moduls 1 mit einem weiteren Dichtelement 7. Auch hier wird der Zwischenraum 17 des thermoelektrischen Moduls 1 durch eine Innenumfangsfläche 2 und eine Außenumfangsfläche 4 umschlossen, wobei die Außenumfangsfläche 4 zumindest teilweise durch eine Hülle 14 gebildet ist. Zwischen den Halbleiterelementen 5 ist weiterhin ein Spalt 13 ausgebildet, der, wie hier gezeigt, eine Öffnung 37 durch die Innenumfangsfläche 2 hin zur Heißseite 18 aufweist. Diese Öffnung 37 zur Heißseite 18 wird aber durch eine Dichtung 28 verschlossen, so dass die Halbleiterelemente 5 bzw. die Verbindungselemente 26 durch den Spalt 13, der insbesondere mit Luft oder einem geeigneten Isolationsmaterial gefüllt ist, thermisch und elektrisch leitend isoliert sind. Das weitere Dichtelement 7 ist über eine Verbindungsstelle 27 mit dem Verbindungselement 26 so verbunden, dass ein im thermoelektrischen Modul 1 erzeugter elektrischer Strom 15 von dem Verbindungselement 26 über die Verbindungsstelle 27 hin zu dem elektrischen Leiter 8 strömt und über eine Sammelanordnung in Form eines zweiten elektrischen Leiters 9, der am elektrischen Leiter 8 angeordnet ist, mit weiteren elektrischen Leitern 8 verbindbar ist. Das Dichtelement 7 ist in radialer Richtung 11 aus mehreren Schichten (10) aufgebaut und weist an seiner Innen- und Außenumfangsfläche Tragelemente 29 auf, die insbesondere metallisch ausgeführt sind und die ein dazwischen angeordnetes ringförmiges Isolationsmaterial als Isolationsschicht 16 aufnehmen. Diese Isolationsschicht 16 dient der elektrischen Isolation des elektrischen Leiters 8 gegenüber der Kaltseite 19.

Fig. 5 zeigt eine dritte Ausführungsvariante des Dichtelements 7 an einem Ende 33 eines thermoelektrischen Moduls 1. Das thermoelektrische Modul 1 weist im Zwischenraum 17 entlang der Achse 3 angeordnete Halbleiterelemente 5 auf, die thermoelektrische Elemente 6 ausbilden. Zwischen den Halbleiterelementen 5 ist ein Spalt 13 angeordnet, der mit der auf der Innenumfangsfläche 2 angeordneten Heißseite 18 verbunden ist. Die Halbleiterelemente 5 sind über Verbindungselemente 26 elektrisch wechselweise miteinander verbunden, so dass bei Bereitstellen einer Kaltseite 19 und einer Heißseite 18 ein elektrischer Strom durch das thermoelektrische Modul 1 erzeugbar ist. An dem Ende 33 wird das thermoelektrische Modul 1 durch ein Dichtelement 7 abgedichtet, wobei ein äußeres ringförmiges Tragelement 29 eine Isolationsschicht 16 umschließt, die ihrerseits den elektrischen Leiter 8 umschließt. Der elektrische Leiter 8 ist über eine Verbindungsstelle 27 mit den Verbindungselementen 26 elektrisch leitend verbunden. Nach Anordnung des Dichtelements 7 wird auf der Innenumfangsfläche 2 eine weitere Isolationsschicht 16 aufgetragen, die sich auch durch die Öffnung 37 der Innenumfangsfläche 2 in die jeweiligen Spalte 13 zwischen den Halbleiterelementen 5 hinein erstreckt und diese Hohlräume zumindest teilweise ausfüllt. Diese besonders bevorzugte Ausführungsvariante eines thermoelektrischen Moduls 1 erlaubt eine besonders einfache Herstellung des thermoelektrischen Moduls 1, wobei nach Anordnung des Dichtelements 7 eine Hülle 14 auf der Außenumfangsfläche 4 angeordnet wird und somit die Außenumfangsfläche 4 des thermoelektrischen Moduls 1 bildet. Die hier nach Anordnung des Dichtelements 7 hinzugefügte Isolationsschicht 16 kann nachträglich wieder im Bereich der Innenumfangsfläche 2 entfernt werden, so dass nur die Spalte 13 und die Öffnungen 37 mit dem Isolationsmaterial gefüllt sind, die Innenumfangsfläche 2 jedoch durch die Verbindungselemente 26 und durch den elektrischen Leiter 8 zumindest teilweise gebildet wird.

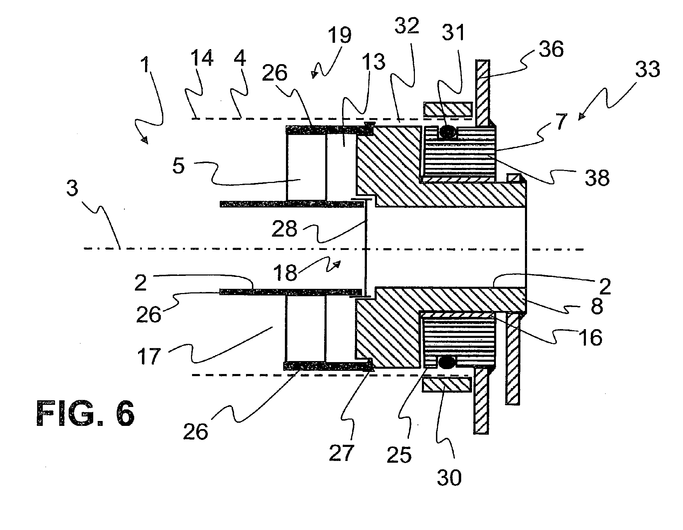

Fig. 6 zeigt eine vierte Ausführungsvariante eines Dichtelements 7, das an einem Ende 33 des thermoelektrischen Moduls 1 angeordnet ist. Hier ist ein mehrteiliges Dichtelement 7 vorgesehen, das mit einem an der Außenumfangsfläche 4 angeordneten Verbindungselement 26 elektrisch leitend verbunden ist. Der elektrische Leiter 8 ist hier als Hülse aufgebaut, die ihrerseits ein weiteres Element 38 des Dichtelements 7 trägt, der vom elektrischen Leiter 8 durch eine Isolationsschicht 16 elektrisch isoliert ist. Dabei ist an der Außenumfangsfläche 4 eine Hülle 14 angeordnet, die an dem Dichtelement 7 zusammen mit einem O-Ring 31 und einem Fixierungselement 30 eine Dichtfläche 25 bildet. Weiterhin ist ein Kleber 32 vorgesehen, der eine Abdichtung des Zwischenraums 17 von der Kaltseite 19 zusätzlich unterstützt. Der elektrische Leiter 8 ist über eine Verbindungsstelle 27, hier eine Schweißverbindung, mit dem Verbindungselement 26 elektrisch leitend verbunden. Die Innenumfangsfläche 2 wird zumindest teilweise durch Verbindungselemente 26 und durch den elektrischen Leiter 8 des Dichtelements 7 gebildet. Der zwischen den Halbleiterelementen 5 bzw. zwischen Halbleiterelementen 5 und dem Dichtelement 7 ggf. vorliegende elektrisch isolierende Spalt 13 ist hier durch eine Dichtung 28 von der Heißseite 18 gasdicht getrennt.

Das Dichtelement 7 weist die folgende weitere Funktion auf, dass das thermoelektrische Modul 1 über das Dichtelement 7 mit einem thermoelektrischen Generator 24 verbunden ist, wobei das Dichtelement 7 über die Befestigung 36 die mechanische Fixierung des thermoelektrischen Moduls 1 innerhalb des thermoelektrischen Generators gewährleistet. Zur besseren Kraftübertragung von der Befestigung 36 über das weitere Element 38 hin zum elektrischen Leiter 8 wird als Isolationsschicht 16 ein Glimmermaterial bevorzugt. Isolationsschicht 16, elektrischer Leiter 8 und das weitere Element 38 werden mechanisch miteinander verpresst, so dass eine rein kraftschlüssige Verbindung der Teile untereinander erzeugt ist. Somit ist eine Verbindung erzeugt, die thermische und mechanische Spannungen und unterschiedliche Ausdehnungen der Teile kompensieren kann ohne zu versagen. Weiterhin kann eine elektrische Isolation zwischen elektrischem Leiter 8 und dem weiteren Element 38 angeordnet sein, so dass infolge der flexiblen Verbindung der Teile miteinander der elektrische Leiter 8 und das weitere Element 38 nicht durch eine Relativbewegung in Richtung der Achse 3 einander kontaktieren. Anstatt dieser zusätzlichen elektrischen Isolierung kann auch ein mechanischer Anschlag vorgesehen werden, der eine derartige Kontaktierung verhindert.

Durch das Dichtelement 7 wird eine konstruktiv sehr einfache Abdichtung des Zwischenraums 17 des thermoelektrischen Moduls 1 gewährleistet, da das Dichtelement 7 sich von der Innenumfangsfläche 2 bis zur Außenumfangsfläche 4 erstreckt und ggf. nur durch die Hülle 14 von der dort angeordneten Kaltseite 19 getrennt ist. Durch die erst nach der Fixierung des Dichtelements 7 angeordnete Hülle 14 kann auf eine aufwendige Toleranzanalyse verzichtet werden, da das Dichtelement 7 in Richtung der Achse 3 sich an die einzelnen Komponenten des thermoelektrischen Moduls 1 anschließt und nicht in eine steife Hülle 14 eingeschoben werden muss, wobei entsprechende Passungen zur Abdichtung zu gewährleisten wären. Vielmehr erfolgt ein Stumpfstoß zwischen elektrischem Leiter 8 des Dichtelements 7 und Verbindungselementen 26 an Verbindungsstellen 27, wobei die Abdichtung des Zwischenraums 17 auf der einen Seite über die Verbindungsstellen 27 und auf der anderen Seite, insbesondere auf der Außenumfangsfläche 4, durch die Hülle 14 in Verbindung mit dem Dichtelement 7 erfolgt.

### Bezugszeichenliste

- 1: Thermoelektrisches Modul
- 2: Innenumfangsfläche
- 3: Achse
- 4: Außenumfangsfläche
- 5: Halbleiterelement
- 6: Thermoelektrisches Element
- 7: Dichtelement
- 8: Elektrischer Leiter
- 9: Zweiter elektrischer Leiter
- 10: Schicht
- 11: Radiale Richtung
- 12: Medium
- 13: Spalt
- 14: Hülle
- 15: Strom
- 16: Isolationsschicht
- 17: Zwischenraum
- 18: Heißseite
- 19: Kaltseite
- 20: Fahrzeug
- 21: Verbrennungskraftmaschine
- 22: Abgassystem
- 23: Kühlsystem
- 24: Thermoelektrischer Generator
- 25: Dichtfläche
- 26: Verbindungselement
- 27: Verbindungsstelle
- 28: Dichtung
- 29: Tragelement
- 30: Fixierungselement
- 31: O-Ring
- 32: Kleber
- 33: Ende
- 34: Distanz
- 3 5: Erstreckung
- 36: Befestigung
- 37: Öffnung
- 38: Weiteres Element

## Patentansprüche

1. Rohrförmiges thermoelektrisches Modul (1) mit einer Innenumfangsfläche (2) und einer Außenumfangsfläche (4), die jeweils einer Heißseite (18) oder einer Kaltseite (19) zugeordnet sind, und einem dazwischen angeordneten Zwischenraum (17) sowie einer geometrischen Achse (3) und mindestens einem Dichtelement (7), wobei das Dichtelement (7) eine Erstreckung (35) in Richtung der Achse (3) hat, die höchstens 20 % einer Länge des Zwischenraums (17) beträgt, **dadurch gekennzeichnet, dass** das Dichtelement (7) zumindest teilweise die Innenumfangsfläche (2) bildet oder nur durch eine elektrische Isolationsschicht (16) von der dort angeordneten Heißseite (18) oder Kaltseite (19) getrennt ist, und das den Zwischenraum (17) an einem Ende (33) des thermoelektrischen Moduls (1) nach außen hin abschließt und zumindest gegenüber der Kaltseite (19) abdichtet und mindestens einen elektrischen Leiter (8) aufweist, der mindestens ein im thermoelektrischen Modul (1) angeordnetes thermoelektrisches Element (6) mit mindestens einem zweiten elektrischen Leiter (9) verbindet, der außerhalb des thermoelektrischen Moduls (1) angeordnet ist.

2. Thermoelektrisches Modul (1) nach Patentanspruch 1, wobei das Dichtelement (7) einteilig ausgeführt ist.

3. Thermoelektrisches Modul (1) nach einem der vorhergehenden Patentansprüche, wobei das Dichtelement (7) aus mehreren Schichten (10) gebildet ist und zumindest die folgenden Funktionen erfüllt:
- Bildung eines elektrischen Leiters (8) zur Leitung eines elektrischen Stroms (15) durch das Dichtelement (7) in einer Richtung der Achse (3),
- Isolationsschicht (16) zur elektrischen Isolation in einer radialen Richtung (11) des thermoelektrischen Moduls (1),
- Abdichtung des Zwischenraums (17) gegenüber einem flüssigen und/oder einem gasförmigen Medium (12).

4. Thermoelektrisches Modul (1) nach einem der vorhergehenden Patentansprüche, wobei das Dichtelement (7) zumindest eine elektrische Isolationsschicht (16) aufweist, und die Isolationsschicht (16) zumindest teilweise ein Glimmermaterial umfasst und nur kraftschlüssig mit dem Dichtelement (7) verbunden ist.

5. Thermoelektrisches Modul (1) nach einem der vorhergehenden Patentansprüche, wobei die Außenumfangsfläche (4) des thermoelektrischen Moduls (1) zumindest teilweise durch eine Hülle (14) gebildet ist und der Zwischenraum (17) des thermoelektrischen Moduls (1) gegenüber der Heißseite (18) und/oder der Kaltseite (19) zumindest durch eine Dichtfläche (2 5) abgedichtet wird, die durch die Hülle (14) und das Dichtelement (7) gebildet wird.

6. Fahrzeug (20) mit einer Verbrennungskraftmaschine (21), einem Abgassystem (22) und einem Kühlsystem (23), wobei ein thermoelektrischer Generator (24) vorgesehen ist, der mindestens ein thermoelektrisches Modul (1) gemäß einem der vorhergehenden Patentansprüche aufweist, wobei sich das Abgassystem (22) durch die Innenumfangsfläche (2) des thermoelektrischen Moduls (1) hindurch und das Kühlsystem (23) außen entlang der Außenumfangsfläche (4) des thermoelektrischen Moduls (1) erstrecken.

## Claims

1. Tubular thermoelectric module (1) having an inner circumferential surface (2) and an outer circumferential surface (4), which are assigned respectively to a hot side (18) or a cold side (19), and having an intermediate space (17), which is arranged therebetween, and a geometric axis (3) and at least one sealing element (7), wherein the sealing element (7) has an extent (35) in the direction of the axis (3), which extent (35) is at most 20% of a length of the intermediate space (17), **characterized in that** the sealing element (7) at least partially forms the inner circumferential surface (2) or is separated from the hot side (18) or cold side (19) arranged there only by an electric insulating layer (16), and which closes off the intermediate space (17) towards the outside at one end (33) of the thermoelectric module (1) and seals the said intermediate space (17) at least with respect to the cold side (19) and has at least one electric conductor (8), which connects at.least one thermoelectric element (6) arranged in the thermoelectric module (1) to at least one second electric conductor (9), which is arranged outside the thermoelectric module (1).

2. Thermoelectric module (1) accoridng to Patent Claim 1, wherein the sealing element (7) is embodied as a single part.

3. Thermoelectric module (1) accoridng to one of the preceding patent claims, wherein the sealing element (7) is formed by a plurality of layers (10) and performs at least the following functions:
- formation of an electric conductor (8) for conducting an electric current (15) through the sealing element (7) in a direction of the axis (3),
- an insulating layer (16) for electric insulation in a radial direction (11) of the thermoelectric module (1),
- sealing of the intermediate space (17) with respect to a liquid and/or a gaseous medium (12).

4. Thermoelectric module (1) accoridng to one of the preceding patent claims, wherein the sealing element (7) has at least one electric insulating layer (16), and the insulating layer (16) at least partially comprises a mica material and is connected to the sealing element (7) only non-positively.

5. Thermoelectric module (1) accoridng to one of the preceding patent claims, wherein the outer circumferential surface (4) of the thermoelectric module (1) is formed at least partially by a sleeve (14), and the intermediate space (17) of the thermoelectric module (1) is sealed off with respect to the hot side (18) and/or the cold side (19) at least by a sealing surface (25), which is formed by the sleeve (14) and the sealing element (7).

6. Vehicle (20) having an internal combustion engine (21), an exhaust system (22) and a cooling system (23), wherein a thermoelectric generator (24) is provided, which has at least one thermoelectric module (1) according to one of the preceding patent claims, wherein the exhaust system (22) extends through the inner circumferential surface (2) of the thermoelectric module (1), and the cooling system (23) extends along the outside of the outer circumferential surface (4) of the thermoelectric module (1).

## Revendications

1. Module (1) thermoélectrique tubulaire ayant une surface (2) périphérique intérieure et une surface (4) périphérique extérieure, qui sont associées respectivement à un côté (18) chaud ou à un côté (19) froid, et un espace (17) intermédiaire disposé entre elles, ainsi qu'un axe (3) géométrique et au moins un élément (7) d'étanchéité, l'élément (7) d'étanchéité ayant une étendue (35) dans la direction de l'axe (3), qui représente au plus 20% d'une longueur de l'espace (17) intermédiaire, **caractérisé en ce que** l'élément (7) d'étanchéité forme, au moins en partie, la surface (2) périphérique intérieure ou n'est séparé que par une couche (7) isolante du point de vue électrique du côté (18) chaud ou du côté (19) froid, qui y est disposée, et **en ce qu'**il ferme vers l'extérieur l'espace (17) intermédiaire à une extrémité (33) du module (1) thermoélectrique et rend étanche, au moins par rapport au côté (19) froid, et a au moins un conducteur (8) électrique, qui relie au moins un élément (6) thermoélectrique disposé dans le module (1) thermoélectrique à au moins un deuxième conducteur (9) électrique, qui est disposé à l'extérieur du module (1) thermoélectrique.

2. Module (1) thermoélectrique suivant la revendication 1, dans lequel l'élément (7) d'étanchéité est réalisé en une pièce.

3. Module (1) thermoélectrique suivant l'une des revendications précédentes, dans lequel l'élément (7) d'étanchéité est formé de plusieurs couches (10) et remplit au moins les fonctions suivantes :
- formation d'un conducteur (8) électrique pour conduire un courant (15) électrique dans l'élément (7) d'étanchéité dans une direction de l'axe (3),
- couche (16) isolante pour isoler électriquement dans une direction (11) radiale du module (1) thermoélectrique,
- étanchéité de l'espace (17) intermédiaire vis-à-vis d'un fluide (12) liquide et/ou gazeux.

4. Module (1) thermoélectrique suivant l'une des revendications précédentes, dans lequel l'élément (7) d'étanchéité a au moins une couche (16) isolante du point de vue électrique et la couche (16) isolante comprend, au moins en partie, du mica et n'est reliée qu'à complémentarité de force à l'élément (7) d'étanchéité.

5. Module (1) thermoélectrique suivant l'une des revendications précédentes, dans lequel la surface (4) périphérique extérieure du module (1) thermoélectrique est formée au moins par un manchon (14) et l'espace (17) intermédiaire du module (1) thermoélectrique est rendu étanche par rapport au côté (18) chaud et/ou au côté (19) froid au moins par une surface (25) d'étanchéité formée par le manchon (14) et l'élément (7) d'étanchéité.

6. Véhicule (20) ayant un moteur (21) à combustion interne, un système (22) pour les gaz d'échappement et un système (23) de refroidissement, dans lequel il est prévu un générateur (24) thermoélectrique, qui a au moins un module (1) thermoélectrique suivant l'une des revendications précédentes, le système (22) pour les gaz d'échappement s'étendant à travers la surface (2) périphérique intérieure du module (1) thermoélectrique et le système (23) de refroidissement, à l'extérieur, le long de la surface (4) périphérique extérieure du module (1) thermoélectrique.
